# EUROPEAN PATENT APPLICATION

(11) **EP 0 985 740 A1**
(43) Date of publication of application: **15.03.2000**
(21) Application number: 98116894.1
(22) Date of filing: 07.09.1998
(51) Int. Cl.: C23C 16/50, C23C 16/30, B05D 7/24

(54) **Super hydrophobic coated substrates**

(71) Applicant: THE PROCTER & GAMBLE COMPANY, Cincinnati, Ohio 45202 (US)
(72) Inventor: D'Agostino, Riccardo, 70126 Bari (IT); Lamendola, Ritalba, 70126 Bari (IT); Favia, Pietro, 70126 Bari (IT); Corzani, Italo, 66100 Chieti (IT); Palumbo, Gianfranco, 61348 Bad Homburg (DE)
(74) Representative: Hirsch, Uwe Thomas M.H.

(57) **Abstract**

This invention deals with a continuous, fluorocarbon thin film with super hydrophobic surface characteristics, i.e. characterized by static water contact angle values higher than about 120°, preferably higher than 130°, more preferably higher than 150°, which is tightly bound to the substrate.

## Description

### Field of the invention

The present invention relates to super hydrophobic coated substrates.

### Background of the invention

Plasma-deposited fluorocarbon coatings are often cited in the literature as "teflon-like coatings" because their CFx (0 < x ≤ 2) composition and surface energy can be made very close to that of polytetrafluoroethylene (PTFE,-(CF₂-CF₂-)ₙ), known on the market as Teflon®.

Plasma coating processes of metals, polymers, and other substrates, with fluorocarbon films are known in the art As an example, it is known from USP 4 869 922 and from other sources, that deposition from continuous (i.e. non modulated) radiofrequency (RF) glow discharges fed with fluorocarbons provides films, layers, tapes, plates, and differently shaped articles made of plastics, metals or other materials, with a thin fluorocarbon coating, with no other material interposed between the coating itself and the substrate. Such coatings are claimed to have very good adherence to the items processed, to be void-free, to be not porous, and to show controlled wettability characteristics, which depend on their surface chemical composition. The non modulated, continuous plasma process of the above mentioned patent leads to coatings characterized by static water contact angle (WCA) values lower than 120°.

Glow discharges treatments are also considered in US-A-5 462 781 for improving the bondability of an implantable polymer medical device or for changing the wettability of a polymer fabric. Several of the references discussed in this patent confirm non modulated, continuous plasma treatments as a means for varying the inherent WCA of a surface.

US-A-5 034 265 discloses a non modulated, continuous plasma treatment for improving the biocompatibility of vascular grafts with a CF_{X} fluorocarbon coating deposited at the inside wall of the grafts in a proper plasma reactor fed with tetrafluoroethylene (C₂F₄, TFE) at 0.2 Torr. In the preferred embodiment of the invention no other materials are interposed between the substrate and the coating.

### Summary of the invention

Specifically, the present invention, having the features mentioned in the annexed claims, relates to substrates coated with a thin, well adherent, nonporous, fluorocarbon coating with super hydrophobic properties, i.e. characterized by static water contact angle (WCA) values, measured on plane surface, higher than about 120°, preferably higher than 130°, more preferably higher than 150°. Substrates treated with this method have their hydrophobicity markedly improved, e.g. can be made effectively waterproof while maintaining their previous characteristics such as permeability to gases and vapors. If the substrates are polymeric, they can be useful e.g. in making breathable products with improved resistance to leakage of body fluids.

The present invention deals with treated polymeric or non polymeric articles whose surface is made super hydrophobic, i.e. characterized by static water contact angle (WCA) values higher than about 120°, preferably higher than 130°, more preferably higher than 150°. The articles are preferably subjected to a modulated glow discharge plasma treatment performed with a fluorocarbon gas or vapor compound fed in a properly configured reactor vessel where the substrates are positioned. The plasma process deposits a continuous, fluorocarbon thin film with super hydrophobic surface characteristics, tightly bound to the substrate.

The substrates of interest for the present invention may include a wide range of materials in form of webs, tapes, films, powders, granules, particles, woven and non-woven layers; substrates can be porous or non-porous, molded or shaped, rigid or flexible, made of polymers, textiles, papers, cellulose derivatives, biodegradable materials, metals, ceramics, semiconductors, and other inorganic or organic materials. Preferably, the substrate is formed into a desired shape or configuration, depending on its intended use, before being subjected to the treatment object of this invention.

When organic synthetic resins are chosen, such substrate materials could be fabricated from polyethylene, polyacrylics, polypropylene, polyvinyl chloride, polyamides, polystyrene, polyurethanes, polyfluorocarbons, polyesters, silicone rubber, hydrocarbon rubbers, polycarbonates and other synthetic polymers.

"Plasma," as used herein, is used in the sense of "low-temperature plasma" or "cold plasma" produced by igniting a glow discharge in a low pressure gas through a power supply. Glow discharges contain a variety of species chemically active and energetic enough to cause chemical reactions with surfaces exposed, i.e. covalent bonding to a suitable substrate material. Cold plasmas, or glow discharges, are generally produced with high frequency (from KHz to MHz and GHz) power supply (HF plasmas). Electrons, positive and negative ions, atoms, excited molecules, free radicals, and photons of various energies are formed in a cold plasma.

"Modulated plasma" means a non continuos plasma, HF plasma, i.e. a glow discharge whose driving power is pulsed between a maximum value and zero (ON/OFF pulse) or a fraction of it, at a certain frequency, with a proper pulse generator connected to the main power supply. In the case of ON/OFF pulsed systems, the time ON and time OFF values are among the experimental parameters of the process. Superimposing a triggering ON/OFF pulse to the main high frequency field which generally drives a glow discharge, alternates short continuous discharges with plasma OFF time intervals where active species still exists in the gas phase, but the effects of ions and electrons are strongly reduced. This alternating exposure to two different processes leads to unique surface modifications of substrates, which are very different from those of continuous plasma process, as it will be shown.

"Plasma deposition" or "plasma polymerization" is the plasma process that leads to the formation of thin (0.01 - 2 µm), partly crosslinked, void-free, continuous coatings well adherent to substrates. The molecules of the gas phase are fragmented by energetic electrons, which are able to break chemical bonds; this process leads to radicals and other chemical species which are able to deposit at surfaces inside the vacuum chamber and form a thin, uniform film. The action of the plasma may also affect the surface of a polymer substrate in the early deposition time; energetic species may break bonds in the substrate with possible evolution of gas products, such as hydrogen, and formation of free radical sites which contribute to form covalent bonds between the growing film and the substrate.

It has been found that it is possible to deposit thin fluorocarbon films with super hydrophobic characteristics, i.e. showing a surprisingly high WCA value, even up to about 165°. The present invention thus provides substrates of the type mentioned above, with fluorocarbon films characterized by a WCA value higher than 120°, preferably higher than 130°, more preferably higher than 150°.

According to the present invention, fluorocarbon coatings with F/C ratio from about 1.50 to about 2.00 have been deposited, characterized by WCA values higher than about 120°, such as between about 155° and about 165°. The coatings have been deposited at the surface of different polymer and non polymer substrates such as polyethylene (PE), polypropylene (PP) polyethyleneterephtalate (PET), and paper in form of films and fabrics, glass and silicon, among many. It should be noted that the F/C ratio could be theoretically up to 3, if the coating would be formed only by a mono-molecular layer of CF₃ groups. But the formation of intermolecular cross-links lowers the above theoretical value so that the obtained coatings, notwithstanding the fact that they contain many CF₃ groups, have a global F/C ratio in the range of about 1.50 to about 2.00.

The thickness of the coatings depends on the duration of the plasma process at different conditions, and can be kept between 0.01 and 2 µm. It has been found that the nature of the substrate materials does not influence neither the chemical composition nor the thickness of the coatings. Coatings with WCA values up to about 165° (e.g. 165° ± 5°)were obtained.

Substrate to be treated are subjected to modulated plasma gas discharge in the presence of at least one fluorocarbon gas or vapor. Specifically, fluorocarbon gases or vapors such as tetrafluoroethylene (TFE,C₂F₄), hexafluoropropene (HFP,C₃F₆), perfluoro-(2-trifluoromethyl-)pentene, perfluoro-(2-methylpent-2-ene) or its trimer may be used, TFE being the presently preferred choice. The plasma deposition process is preferably performed by positioning the substrate in a properly arranged plasma reactor, connecting the reactor to a source of a fluorocarbon gas or vapor, regulating flow and pressure of the gas inside the reactor, and sustaining a glow discharge in the reactor with a high frequency electric field in a pulsed (modulated) mode by means of a suitable pulsed power supply. The parameters which define the glow discharge treatment includes the feed gas or vapor, its flow rate, its pressure, the position of the substrate inside the reactor, the design of the reactor, the exciting frequency of the power supply, the input power, the time ON and the time OFF of the pulsing system. Substrates, as those listed in the abstract, may be positioned in the "glow" region of the discharge, i.e. directly exposed to the plasma, or in the "afterglow" region, i.e. downstream respect to the visible glow. The two positions generally result in coatings with different composition and properties; treating the substrates with modulated glow discharge results also in different coatings respect to continuous treatments.

### Brief description of the drawings

In the following detailed description the invention will be described, purely by way of example, with reference to the enclosed figures of drawing, wherein:
- Figure 1 compares a conventional "continuous" RF glow discharge with an ON/OFF "modulated" RF glow discharge;
- Figure 2 portrays a typical scheme of a plasma reactor adapted for use within the context of the invention;
- Figure 3 shows a C1s ESCA signal of an uncoated polyethylene substrate wherein the signal is due only to C-H, C-C bonds of the substrate;
- Figure 4 shows a C1s ESCA signal of a PE substrate coated with a fluorocarbon coating deposited as described in example 1 (glow position, continuous mode), with WCA of 100 ± 5°; the signal is composed by components due to CF3, CF2, CF and CCF bonds of the fluorocarbon coating, and to C-H, C-C bonds due to surface contamination;
- Figure 5 shows a C1s ESCA signal of a PE substrate coated with a fluorocarbon coating deposited as described in example 1 (afterglow position, continuous mode), with WCA of 120 ± 5°; the signal is composed by components due to CF3, CF2, CF and CCF bonds of the fluorocarbon coating, and to C-H, C-C bonds due to surface contamination; and
- Figure 6 shows a C1s ESCA signal of a PE substrate coated with a fluorocarbon coating deposited as described in example 1 (glow position, modulated mode), with WCA of 165 ± 5°; the signal is composed by components due to CF3, CF2, CF and CCF bonds of the fluorocarbon coating, and to C-H, C-C bonds due to surface contamination.

### Detailed description of the invention

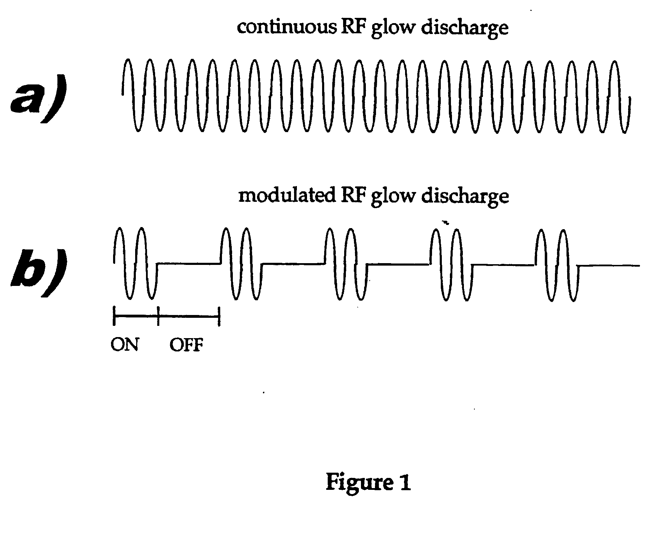

Figure 1 compares a conventional "continuous" plasma (figure 1a) with the modulated process of the invention, (figure 1b) showing pulsed alternating plasma ON with plasma OFF (i.e. no plasma) times. The two processes are schematized by referring to their driving signals.

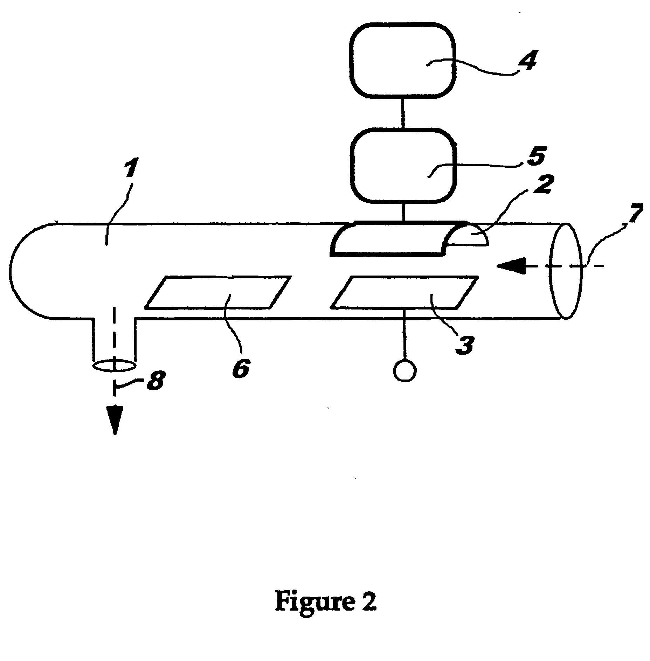

The reactor 1 schematically shown in figure 2 was utilized not exclusively for developing the deposition method object of the present invention. The reactor vacuum chamber 1 is made of Pyrex glass, is provided with an external RF powered electrode 2 and an internal grounded electrode 3. The external electrode is connected to a power supply 4 (typically a radiofrequency generator operating at e.g. 13.56 MHz) through a matching network and an ON/OFF pulse generator 5. The substrates can be treated in the "glow" region of the reactor, onto the grounded electrode 3, as well as in its "afterglow" position i.e. at an afterglow substrate holder 6. The gas/vapor is fed through a proper mass flowmeter through a gas/vapor feeding manifold 7, and its pressure, measured at the pump out exit 8 of the reactor, kept at a certain constant value with a manual valve on the vacuum connection between the reactor and its pumping unit. Even though the arrangement shown in the drawing represents a presently preferred choice, those skilled in the art will immediately recognize that pulsed energization of the plasma reactor can be achieved by different means such as direct energization by means of pulsed RF generators commonly used in radar and telecommunication techniques.

Preferably, the deposition process is performed with an RF (13.56 MHz) generator. The RF power delivered to the external electrode of the reactor is kept in the 1-500 Watts range for a power density of 0.02-10 Watt/cm². The reactor is fed with a fluorocarbon compound at a 1-100 sccm flow rate and is kept at a constant pressure of 50-1000 mTorr during the process. Preferably, the glow discharges are modulated through the pulse generator, preferably at 1-500 ms time ON and 1-1000 ms time OFF values, with respective values of about 10 ms and about 190 ms being the most preferred choice at present. The deposition process may range from a few seconds to many hours; during this time a uniform fluorocarbon coating is deposited on the substrates positioned in the glow as well as on those in the afterglow region. The deposition rate, a typical one being in the 20 - 400 Å/min range, was measured by weighing (weight/time) the substrates before and after the discharge, or by measuring the thickness of the coatings (thickness/time) with an Alpha Step profilometer. The deposition rate and the chemical composition of the coating depend on the experimental conditions (pressure, power, substrate position time ON, time OFF, gas feed and flow rate) of the discharge.

The coatings obtained are uniform over the entire surface of the substrate; when deposited on flat, smooth substrates, their hydrophobic character has been estimated through their static WCA value, as measured with a WCA goniometer. WCA values in the range about 120° to about 165°, corresponding to a critical surface tension lower than that of PTFE (18 dynes/cm) have been measured for fluorocarbon CFx coatings, when x ranges between about 1.50 and about 2.00. The chemical composition of coatings is preferably determined by Electron Spectroscopy for Chemical Analysis (ESCA) within the sampling depth of the technique (about 100 A). The adherence of the coating to the substrate is very good.

The following examples are given for the purpose of still better illustrating the inventive concept of the present invention, and for highlighting the advantages of using modulated over continuous treatments.

### EXAMPLE 1

Three sets of substrates of silicon, PE and PP, of areas in the range of 2-10 cm² per substrate, were positioned onto the grounded electrode 3 of the reactor schematized in Figure 2. A similar set of substrates was positioned in the after-glow position at 6. C₂F₄ was set to feed continuously the reactor at 6 sccm, and the pressure set at 300 mTorr. The RF generator was connected to the reactor and allowed to sustain the discharge with 50 Watt of input power for 90 min, then switched off.

Another glow discharge was subsequently run with a similar set of substrates positioned in the glow position and no substrates in the afterglow position, under the same conditions described above except for the fact that modulation was effected at 10 ms time ON and 190 ms time OFF through the pulse generator.

At the end of the two discharges the substrates were extracted from the reactor and their WCA measured. The WCA values shown in Table 1 were found, which are compared to the WCA values of the unprocessed substrates. A deposition rate of 30 ± 5 Å/mm was measured for the coatings deposited in the modulated mode.

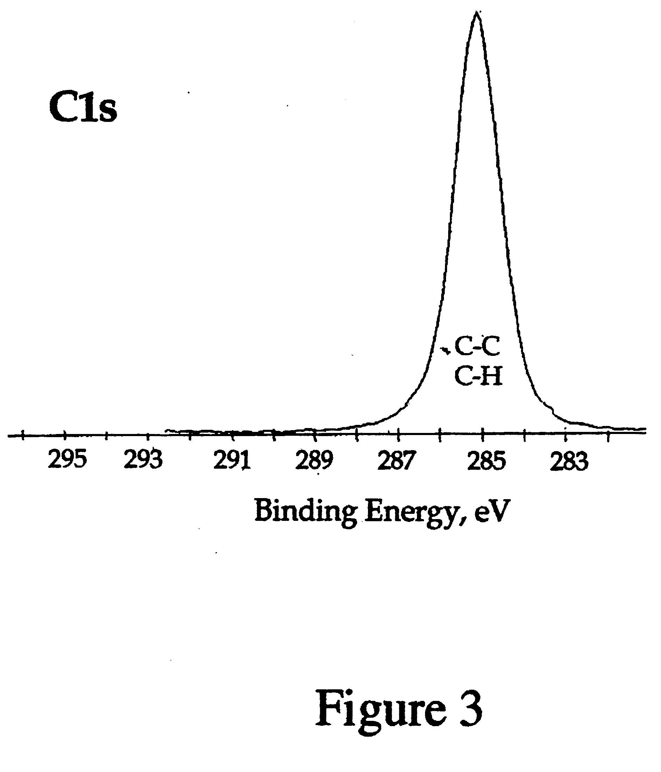

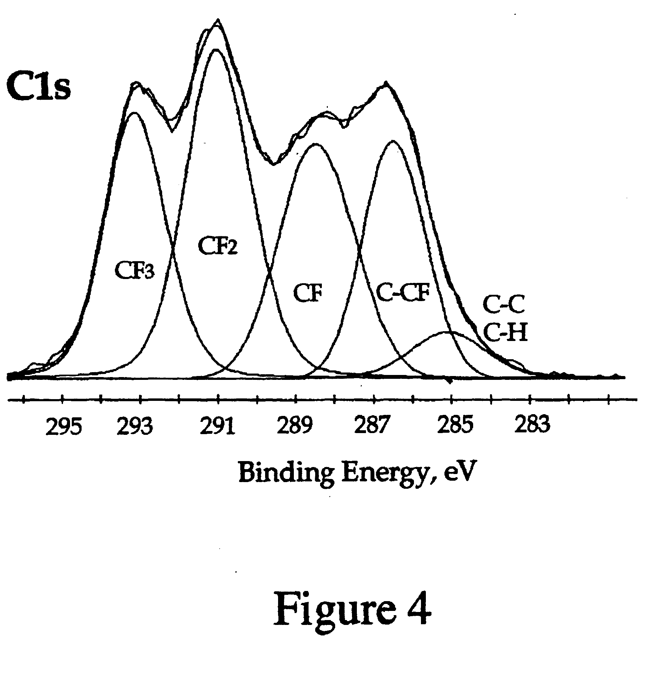

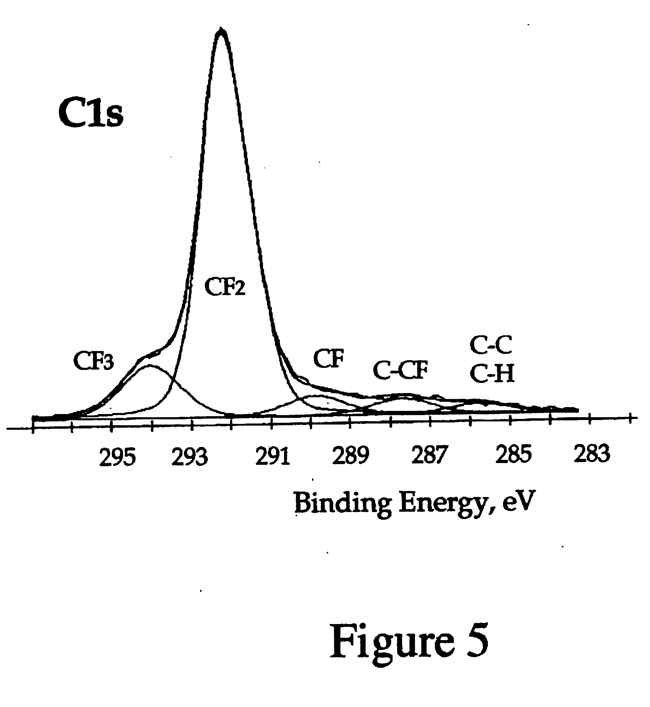

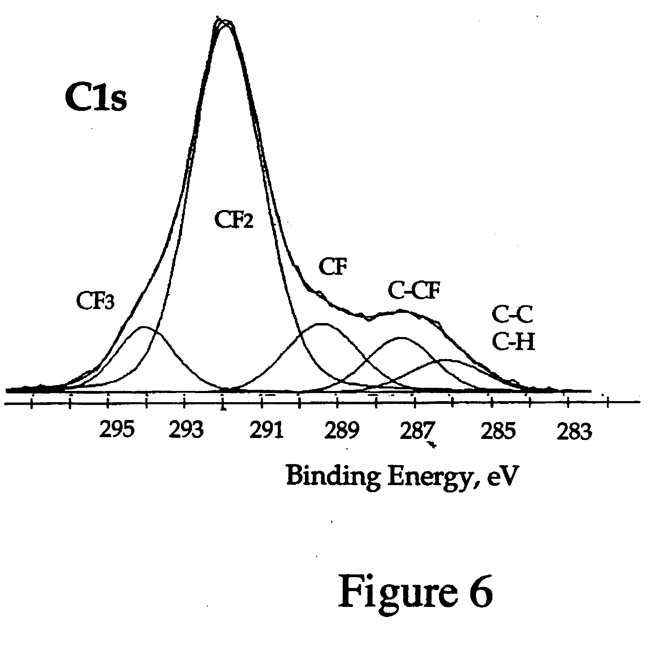

Other substrates, treated in the two modes, where analysed with the ESCA technique. Their surface composition resulted to be entirely composed by carbon and fluoride, according to the results shown in Tables 2a-c. No other elements were detected (e.g. Si for silicon substrates), which means that the coatings are continuous. The C1s spectrum of the uncoated PE substrate is shown in Figure 3, while the C1s spectra of PE samples coated as described above are shown in Figures 4, 5 and 6, respectively.

**Table 1**

| SUBSTRATE | Si | PE | PP |
|---|---|---|---|
| WCA unprocessed | 15° ± 3° | 95° ± 3° | 85° ± 3° |
| WCA continuous discharge (glow position) | 100° ± 5° | 100° ± 5° | 100° ± 5° |
| WCA continuous discharge (afterglow position) | 120° ± 5° | 120° ± 5° | 120° ± 5° |
| WCA modulated discharge (glow position) | 165° ± 5° | 165° ± 5° | 165° ± 5° |

**Table 2a**

| ESCA results for the continuous discharge (glow position) of Example 1 | | | |
|---|---|---|---|
| COATED SUBSTRATE | Si | PE | PP |
| carbon atomic % | 43.3 | 42.4 | 42.9 |
| fluorine atomic % | 56.7 | 57.6 | 57.1 |
| F/C ratio | 1.31 | 1.36 | 1.33 |

**Table 2b**

| ESCA results for the continuous discharge (afterglow position) of Example 1 | | | |
|---|---|---|---|
| COATED SUBSTRATE | Si | PE | PP |
| carbon atomic % | 34.4 | 33.8 | 34.1 |
| fluorine atomic % | 65.6 | 66.2 | 65.9 |
| F/C ratio | 1.91 | 1.96 | 1.93 |

**Table 2c**

| ESCA results for the modulated discharge (glow position) of Example 1 | | | |
|---|---|---|---|
| COATED SUBSTRATE | Si | PE | PP |
| carbon atomic % | 36.4 | 36.2 | 36.7 |
| fluorine atomic % | 63.6 | 63.8 | 63.3 |
| F/C ratio | 1.75 | 1.76 | 1.72 |

### EXAMPLE 2

Three sets of substrates of glass, silicon and PE, of areas in the range of 2-10 cm² per substrate, were positioned onto the grounded electrode 3 of the reactor schematized in Figure 2. A similar set of substrates was positioned in the after-glow position. C₃F₆ was set to feed continuously the reactor at 5 sccm, and the pressure set at 300 mTorr. The RF generator was connected to the reactor and allowed to sustain the discharge with 50 Watt of input power for 60 min, then switched off.

Another glow discharge was subsequently run with a similar set of substrates positioned in the glow position and no substrates in the afterglow, under the same conditions described above except for the fact that modulation was effected at 10 ms time ON and 90 ms time OFF through the pulse generator.

At the end of the two discharges the substrates were extracted from the reactor and their WCA measured. The WCA values shown in Table 3 were found, which are compared to the WCA values of the unprocessed substrates. A deposition rate of 70 ± 5 Å/mm was measured for the coatings deposited in the modulated mode.

Other substrates, treated in the two modes, where analysed with the ESCA technique; their surface composition resulted to be entirely composed by carbon and fluoride, according to the results shown in Tables 4a-c. Also for this case, since no other elements were detected (e.g. Si for silicon and glass substrates), the coatings were assumed to be continuous.

**Table 3**

| SUBSTRATE | glass | Si | PE |
|---|---|---|---|
| WCA unprocessed | 35° ± 3° | 15° ± 3° | 95° ± 3° |
| WCA continuous discharge (glow position) | 105° ± 5° | 105° ± 5° | 105° ± 5° |
| WCA continuous discharge (afterglow position) | 120° ± 5° | 120° ± 5° | 120° ± 5° |
| WCA modulated discharge (glow position) | 120° ± 5° | 120° ± 5° | 120° ± 5° |

**Table 4 a**

| ESCA results for the continuous discharge (glow position) of Example 2 | | | |
|---|---|---|---|
| COATED SUBSTRATE | glass | Si | PE |
| carbon atomic % | 42.7 | 42.1 | 41.5 |
| fluorine atomic % | 57.3 | 57.9 | 58.5 |
| F/C ratio | 1.34 | 1.37 | 1.41 |

**Table 4 b**

| ESCA results for the continuous discharge (afterglow position) of Example 2 | | | |
|---|---|---|---|
| COATED SUBSTRATE | glass | Si | PE |
| carbon atomic % | 37.1 | 38.3 | 38.1 |
| fluorine atomic % | 62.9 | 61.7 | 61.9 |
| F/C ratio | 1.69 | 1.61 | 1.62 |

**Table 4 c**

| ESCA results for the modulated discharge (glow position) of Example 2 | | | |
|---|---|---|---|
| COATED SUBSTRATE | glass | Si | PE |
| carbon atomic % | 38.1 | 39.9 | 39.2 |
| fluorine atomic % | 61.9 | 60.1 | 60.8 |
| F/C ratio | 1.62 | 1.51 | 1.55 |

### EXAMPLE 3

Three set of substrates of polished silicon, polyethyleneterephtalate (PET), and 3 mm thick FAM (Functional Absorbent Material), an hydrophilic absorbent material made according to the teachings of USP 5 260 345, of areas in the range of 2-10 cm² per substrate, were positioned onto the grounded electrode 3 of the reactor schematized in Figure 1. C₂F₄ was set to feed continuously the reactor at 5 sccm, and the pressure set at 400 mTorr. The RF generator was connected to the reactor and allowed to sustain the discharge for 20 min in the modulated mode (10 ms time ON; 190 ms time OFF) with 75 Watt of input power. At the end of the discharge the substrates were extracted from the reactor, and their WCA measured. The values shown in Table 5 were found, which are compared to the WCA values of the unprocessed substrates. A deposition rate of 300 ± 10 Å/min was measured.

Other substrates where ESCA analysed; their surface composition resulted to be entirely composed by carbon and fluoride, according to the results shown in Table 6. No other elements have been detected (e.g. Si for silicon substrates, and O for PET substrates ), thus the coatings can be assumed to be continuous.

The coated FAM substrate was cut along its thickness, and the freshly cut surface, which was not directly exposed to the discharge, analysed by WCA and ESCA measurements. The data shown in Table 7 demonstrate that the thick FAM sample was treated not only on the surface exposed to the glow, but also inside its bulk, which demonstrates that the plasma treatment is able to penetrate through porous substrates.

**Table 5**

| SUBSTRATE | PET | Si | FAM |
|---|---|---|---|
| WCA unprocessed | 75° ± 3° | 15° ± 3° | WCA unmeasurable, the drop is adsorbed by the material |
| WCA modulated discharge (glow position) | 155° ± 5° | 155° ± 5° | 155° ± 10° |

**Table 6**

| ESCA results for the modulated discharge (glow position) of Example 3 | | | |
|---|---|---|---|
| COATED SUBSTRATE | PET | Si | FAM |
| carbon atomic % | 34.8 | 35.6 | 34.0 |
| fluorine atomic % | 65.2 | 64.4 | 66.0 |
| F/C ratio | 1.87 | 1.81 | 1.94 |

**Table 7**

| ESCA results for the treated FAM sample of Example 3 cut just after the treatment | |
|---|---|
| SUBSTRATE | bulk FAM, cut after the treatment |
| WCA(modulated discharge) | the drop of water is not absorbed |
| | the material is evidently much more hydrophobic respect to the untreated one |
| | WCA is unmesurable due to surface roughness |
| carbon atomic % | 38.5 |
| fluorine atomic % | 61.5 |
| F/C ratio | 1.60 |

## Claims

1. A surface treated substrate having a fluorocarbon coating characterized in that said treated surface has a static water contact angle (WCA) higher than 120°.

2. The substrate of claim 1 characterized in that said treated surface has a static water contact angle (WCA) higher than 130°, preferably between 130° and 165°, most preferably between 155° and 165°.

3. The substrate of claims 1 or 2 characterized in that said coating is a fluorocarbon coating.

4. The substrate of claim 3 characterized in that said coating exhibits a fluorine/carbon ratio (F/C) of between about 1.50 and about 2.00, preferably between about 1.60 and about 1.95, most preferably substantially equal to 1.75.

5. The substrate of any preceding claim characterized in that said substrate is selected in the group consisting of polyethylene, polyacrylics, polypropylene, polyvinyl chloride, polyamides, polystyrene,polyurethanes, polyfluorocarbons, polyesters, silicon rubber, hydrocarbon rubbers, polycarbonates, cellulose and its derivatives, rubber, glass, semiconductors, metals.

6. The substrate of any preceding claim characterized in that said substrate is made of a porous material, the porosity of the substrate being substantially unaffected by said coating, preferably said porous material is a perforated film or a fibrous woven or non woven material or a open cell foam material.

7. The substrate of any preceding claim characterized in that said substrate is a flexible substrate.

8. The substrate of any preceding claim obtainable by exposing the substrate to a modulated plasma glow discharge in the presence of a fluorocarbon gas or vapor.

9. The substrate of claim 8 characterized in that said modulation for said plasma glow discharge is generated as a radio frequency or a pulsed mode including subsequent time on and time off intervals.

10. The substrate of claims 8 or 9 characterized in that said gas is selected in the group consisting of tetrafluoroethylene, hexafluoropropene, perfluoro-(2-trifluoromethyl-) pentene, perfluoro-(2-methylpent-2-ene) and its trimer thereof.
